# EUROPÄISCHE PATENTSCHRIFT

(11) **EP 0 532 909 B1**
(45) Veröffentlichungstag und Bekanntmachung des Hinweises auf die Patenterteilung: **17.05.1995**
(21) Anmeldenummer: 92113783.2
(22) Anmeldetag: 13.08.1992
(51) Int. Cl.: G01D 5/244, H03K 5/08, G01P 3/48

(54) **Einrichtung zur Auswertung periodischer Signale von induktiven Gebern**
Device for the evaluation of periodic signals from inductive sensors
Dispositif pour analyser des signaux périodiques de capteurs inductives

(30) Priorität: 19.09.1991 DE 4131128
(43) Veröffentlichungstag der Anmeldung: 24.03.1993
(73) Patentinhaber: DAIMLER-BENZ AKTIENGESELLSCHAFT, 70567 Stuttgart (DE)
(72) Erfinder: Setzer, Jürgen, W-7132 Illingen (DE); Braun, Hans, Ing., W-7000 Stuttgart 50 (DE); Stein, Hermann, Ing., W-7053 Kernen (DE)

(56) Entgegenhaltungen:
- EP-A- 0 282 732
- DE-A- 2 843 981
- DE-A- 3 936 831
- ELEKTROTECHNIK Bd. 66, Nr. 5, 19. M rz 1984, W RZBURG,DEUTSCHLAND Seite 61 'Drehzahlgeber mit der Magnetschranke HKZ 101'

## Beschreibung

Die Erfindung geht aus von einer Einrichtung zur Auswertung periodischer Signale von induktiven Gebern nach dem Oberbegriff des Anpruchs 1.

Aus der DE-PS 22 35 056 ist eine Schaltungsanordnung für einen induktiven Aufnehmer bekannt, in welchem durch Änderung der äußeren magnetischen Verhältnisse durch periodisch vorbeibewegte Teile eine Wechselspannung induziert wird, mit einer Schwellwertschaltung, die diese Wechselspannung dann in eine Impulsfolge gleicher Frequenz umformt. Dazu wird die Wechselspannung an den Eingang eines Spitzenwertgleichrichters gelegt, der aus dem Spitzenwert eine proportionale Gleichspannung bildet, welche der Schwellwertschaltung zugeführt wird um deren Einschaltpegel so zu beeinflussen, daß der Spitzenwert besagter Wechselspannung gerade noch die Schwellwertschaltung zum Kippen bringt. Ein grundlegender Nachteil dieser Schaltungsanordnung ist, daß sie den drehzahlabhängigen, und dies heißt im allgemeinen frequenzabhängigen, Phasenfehler nicht beseitigt, welcher durch die frequenzabhängige induktive Blindkomponente des Innenwiderstandes des Gebers verursacht wird.

Aus der Druckschrift "Motor-Elektronik", 1983 herausgegeben von der Robert Bosch GmbH, ist eine Einrichtung zur Auswertung periodischer Signale von induktiven Gebern bekannt. Beispielhaft ist dort ein solcher Geber ein Kurbelwellenwinkelgeber, der eine drehzahlanaloge Wechselspannung abgibt. Um diese Wechselspannung in einem elektronischen Steuergerät verarbeiten zu können, wird die Wechselspannung mittels eines Schmitt-Triggers in rechteckförmige Stromimpulse umgeformt; die feste Hysterese des Schmitt-Triggers erhöht dabei zugleich die Unempfindlichkeit gegenüber bestimmten Störungen. Störungen, die über die Hystereseschwelle des Schmitt-Triggers hinausreichen, führen allerdings zu Fehlimpulsen am Ausgang des Schmitt-Triggers.

Die DE-OS 34 33 777 beschreibt eine diesbezügliche Verbesserung, indem eine Triggerschwelle des SchmittTriggers in Abhängigkeit vom Signal eines Spitzenwertdetektors verschoben wird. Das Ergebnis ist eine von verschiedenen Geberamplituden abhängige adaptive Impulsformung, welche eine verbesserte Störsicherheit bieten soll. Weiter wird vorgeschlagen, im Falle einer wünschenswert phasengenauen Erfassung des Gebersignals eine Triggerschwelle des Schmitt-Triggers fest einzustellen, insbesondere auf den Nulldurchgang der Geberspannung.

Die EP-A-0 282 732 beschreibt eine Schaltungsanordnung zur Auswertung der Signale eines induktiven Meßwertaufnehmers. Sie umfaßt einen Spitzenwertdetektor, der vom induktiven Geber mit dem Gebersignal beaufschlagbar ist, um in Abhängigkeit von der Gebersignalamplitude den Übergang von einem ersten in einen zweiten logischen Zustand am Ausgang eines Vergleichers zu beeinflussen, wobei dem ersten Eingang des Vergleichers ein vom Spitzenwert abgeleitetes Signal und dem zweiten Eingang des Vergleichers das Gebersignal zugeführt wird. Damit soll erreicht werden, daß Gebertoleranzen und Temperaturschwankungen sich nicht auf das Ausgangssignal auswirken.

Die DE-OS 39 36 831 beschreibt ebenfalls eine Schaltungsanordnung zur Aufbereitung des Ausgangssignals eines Drehzahlsensors. Sie besteht im wesentlichen aus einer Triggerschaltung, deren Umschaltpunkte oder "Hysterese" steuerbar sind, und ist mit Schaltkreisen zur Ermittlung eines Kopplungsfaktors und mit Schaltkreisen zur Einstellung der Hyseresen in Abhängigkeit von diesem Kopplungsfaktor ausgerüstet. Dabei wird die Amplitude des Sensorausgangssignals gewonnen durch Multiplikation des Kopplungsfaktors mit der Frequenz des Sensorsignals. Damit sollen eine Verbesserung des Signalstörabstandes und eine Vergrößerung der zulässigen Montagetoleranzen bei der Installation des Gebers erreichbar sein.

Ein Nachteil dieser bekannten Einrichtung bzw. Schaltungen ist, daß sie den oben erwähnten frequenzabhängigen Phasenfehler nicht beseitigen. Eine "phasengenaue Erfassung" ist bei den vorgenannten Einrichtungen bzw. Schaltungen allenfalls bei jeweils einer bestimmten Drehzahl eines zu überwachenden Rotationselements bzw. einer festen Frequenz des Gebersignals möglich, sofern damit eine eindeutige Zuordnung zwischen Augenblicksspannung und Position des bezüglich seiner Drehposition abzutastenden Rotationselements verstanden wird.

Aufgabe der Erfindung ist es, eine Einrichtung zur Auswertung periodischer Signale von induktiven Gebern zu schaffen, die einen erheblich reduzierten Phasenfehler im gesamten Nennfrequenzbereich periodischer Eingangssignale aufweist.

Diese Aufgabe wird mit den Merkmalen des Anspruchs 1 gelöst.

Der wesentliche Vorteil der erfindungsgemäßen Einrichtung besteht darin, daß das Nacheilen des periodischen Signals eines induktiven Gebers bei wachsender Frequenz, etwa bei wachsender Drehzahl eines kontinuierlich abzutastenden Teils, kompensiert wird, wodurch z.B. der absolute Bezugsfehler zwischen der tatsächlichen Position des abzutastenden Teils und dem diese Position charakterisierenden Augenblickswert des Gebersignals verringert wird. Eine die Bezugsgenauigkeit weiter steigernde Einflußnahme auf eine zur Weiterverarbeitung vorgesehene Signalflanke in Abhängigkeit von der Amplitude des Gebersignals wird dabei integral mitumfaßt.

Vorteilhafte Weiterbildungen sind nach Lehre der abhängigen Ansprüche 2 bis 12 gegeben.

Zwei Ausführungsbeispiele der Erfindung sind in der Zeichnung dargestellt und in der nachfolgenden Beschreibung erläutert. Es zeigen:
- **Figur 1a**: eine zeitnormierte, schematische Veranschaulichung der Verschiebung eines aus einem induktiven Gebersignal ableitbaren Triggerzeitpunktes;
- **Figur 1b**: eine schematische Veranschaulichung der amplitudenabhängigen Verschiebung einer aus einem periodischen Gebersignal ableitbaren Triggerflanke;
- **Figur 2**: das Blockschaltbild der erfindungsgemäßen Einrichtung;
- **Figur 3**: das Wirkschaltbild eines ersten Ausführungsbeispiels;
- **Figur 4**: das Wirkschaltbild eines zweiten Ausführungsbeispiels.

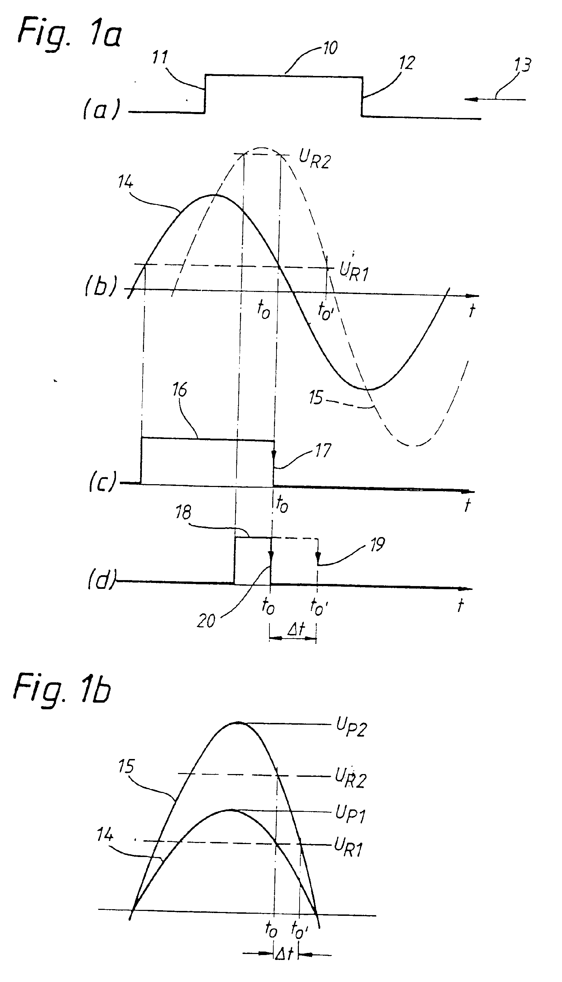

In Zeile (a) der **Figur 1a** ist ein z.B. in Pfeilrichtung 13 beweglicher Zahn 10 eines induktiven Gebers veranschaulicht. Vermöge magnetflußverändernder Zahnflanken 11 und 12 bewirkt er in der Wicklung des Gebers eine Signalspannung, deren Frequenz durch die Frequenz entsprechender Magnetfeldänderungen und deren Amplitude durch die Induktivität des Gebers und durch das Maß der Änderung der Kraftflußdichte bestimmt wird, welcher die Induktivität ausgesetzt wird.

In Zeile (b) sind zwei solche Signalspannungen 14 und 15 für verschiedene Frequenzen zeitnormiert über der Zeit dargestellt. Es ist ersichtlich, daß die einer höheren Frequenz zugeordnete, höhere Signalspannung 15 der einer niedrigeren Frequenz zugeordneten, niedrigeren Signalspannung 14 zeitlich nacheilt. Eine von entsprechenden Spannungen gespeiste Triggerschaltung, die z.B. in Abhängigkeit von der eingangsseitigen Überschreitung eines Referenzpegels U_{R1} ein Signal 16 mit dem logischen Zustand L gemäß Zeile (c) abgibt, erzeugt so zum Zeitpunkt tₒ eine weiterverarbeitbare fallende Flanke 17, welcher insoweit eine bestimmte Augenblicksposition eines (mit besagtem Geberzahn verbundenen) beweglichen Teils zuzuordnen ist.

Bewegt sich besagtes Teil schneller, bewirkt allein schon die vorerwähnte Zeitverschiebung der Signalspannung 15 gegenüber der Signalspannung 14 eine normiert um Delta t in den Zeitpunkt t_{o′} verzögerte abfallende Flanke 19 in einem entsprechend aufbereiteten Positionssignal 18. **Figur 1b** verdeutlicht, daß aber auch ohne Änderung der Bewegung besagten Teils bereits eine Änderung der Kraftflußwechselverhältnisse, etwa infolge schwankender Luftspaltbreite zwischen Geberzahn und induktivem Teil des Gebers, eine entsprechend normierte Zeitverschiebung Delta t verursacht. Erreicht die Signalspannung die Spitzenspannung U_{P2}, wird die eine entsprechende Abfallflanke auslösende Schwellenspannung U_{R1} zu einem gegenüber dem Zeitpunkt tₒ um Delta t verzögerten Zeitpunkt t_{o′} erreicht. Durch Anheben der Schwellenspannung U_{R1} auf den höheren Wert U_{R2} kann eine solche Verzögerung vermieden werden. Aus Zeile (d) der **Figur 1a** ist insoweit entnehmbar, daß eine offenbar in Abhängigkeit von der Frequenz und von der Signalamplitude vorzunehmende Anhebung einer kleineren Schwellenspannung U_{R1} auf eine höhere Schwellenspannung U_{R2} zu einer zeitlichen Gleichlage der abfallenden Signalflanken 17 und 20 führen kann.

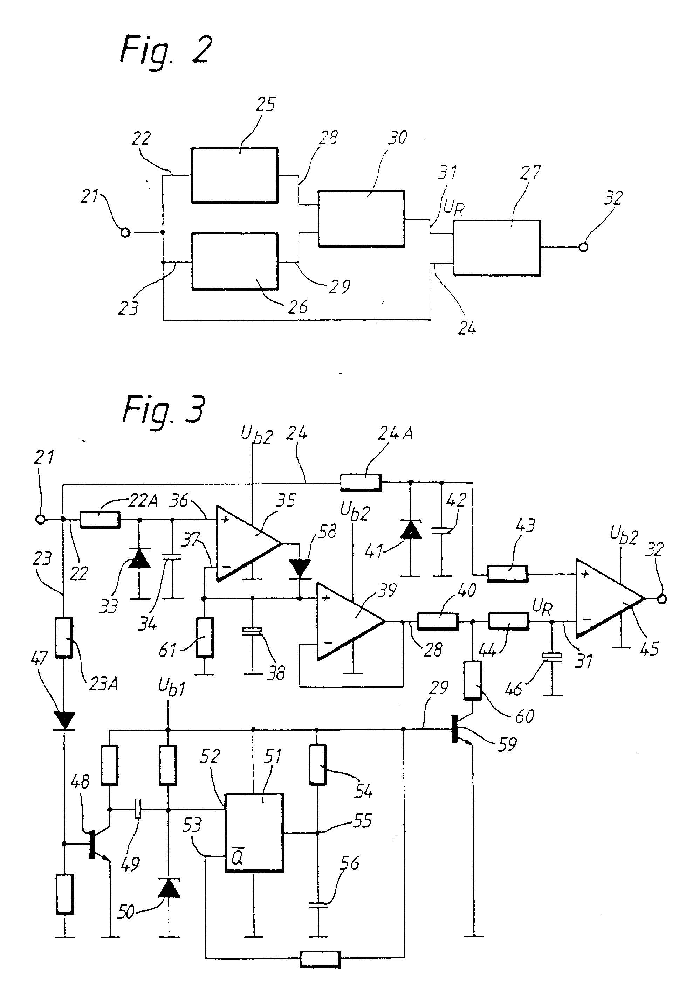

Diese Funktion leistet die Einrichtung gemäß **Figur 2.** Von einer Eingangsklemme 21 gelangt das Gebersignal an den Eingang 22 eines Spitzenwertdetektors 25, den Eingang eines Impulsgenerators 26 und den zweiten Eingang 24 eines Komparators 27. Die Ausgänge 28 und 29 des Spitzenwertdetektors 25 und des Impulsgenerators 26 speisen eine Gewichtungsstufe 30, deren Ausgang mit dem ersten Eingang 31 besagten Komparators 27 verbunden ist. Dessen Ausgang ist an die Ausgangsklemme 32 geführt, an welcher das phasenkompensierte Gebersignal abnehmbar ist.

Die Einrichtung funktioniert wie folgt.

Der Spitzenwertdetektor 25 gibt eine Ausgangsspannung ab, die dem augenblicklichen Spitzenwert des an der Klemme 21 anliegenden Eingangssignal entspricht. Der Impulsgenerator 26 wird synchron zum Gebersignal getriggert und liefert an seinem Ausgang einen kontinuierlichen Puls mit z.B. konstanter Impulsdauer, jedoch mit über zunehmender Gebersignalfrequenz abnehmender Pulspausendauer, d.h. mit entsprechend zunehmendem Tastverhältnis. Die Impulsdauer muß also so kurz gewählt werden, daß auch bei der höchsten praktisch vorkommenden Frequenz des Gebersignals das Tastverhältnis kleiner 1 bleibt.

Der entsprechende Puls wird in der Gewichtungsstufe 30, die beispielsweise als Multiplizierer realisiert sein kann, integriert und mit dem Ausgangssignal des Spitzenwertdetektors 25 gewichtet. Am Ausgang 31 wird die benötigte, über der Frequenz und Amplitude des Gebersignals "gleitende" Schwellenspannung U_{R} ausgegeben, die dem Komparator 27 als Bezugsspannung für den Vergleich mit dem Augenblickswert der Signalspannung des Gebers dient. Auf diese Weise wird bei Erhöhung der Frequenz und/oder der Spannung des Gebersignals der an die Ausgangsklemme 32 abgegebene Puls im Sinne der **Figur 1a** Zeile (d) kompensiert, so daß eine von der absoluten Größe des Gebersignals und seiner Frequenz zeitlich nicht abhängige Abfallflanke des Signals an der Ausgangsklemme 32 erreicht wird.

Die Impulserzeugung und Gewichtung kann aber genau so gut im Rahmen einer integrierten Funktion erfolgen, wie weiter unten beispielhaft ausgeführt.

**Figur 3** veranschaulicht anhand eines Wirkschaltbildes die praktische Realisierung und Funktion eines ersten Ausführungsbeispiels der Einrichtung gemäß Figur 2.

Über einen ersten Entkopplungswiderstand 22A ist das Gebersignal von Klemme 21 an eine Diode 33 geführt. Letzterer ist zur Abfilterung hochfrequenter Störspitzen ein Kondensator 34 parallel geschaltet. Das so gereinigte Gebersignal ist an den positiven Eingang eines Verstärkers 35 geführt, von dessen niederohmigem Ausgang der Signalspitzenwert über eine Diode 58 auf einen Speicherkondensator 38 übertragen wird. Ein dem Kondensator 38 parallelgeschalteter Widerstand 61 sorgt für eine gewisse stetige Entladung des Kondensators 38, so daß die Kondensatorspannung Änderungen des Gebersignals am Eingang folgen kann.

Die die Amplitude des Gebersignals insoweit abbildende Spannung am Kondensator 38 steht am Ausgang 28 des als Impedanzwandler geschalteten Verstärkers 39 an noch niedrigerem Innenwiderstand an. Sie wird über die Widerstände 40 und 44 auf den Glättungskondensator 46 übertragen, der insoweit eine Tiefpaß- bzw. Integrationsfunktion realisiert.

Über einen zweiten Entkopplungswiderstand 23A ist das Gebersignal von Klemme 21 über eine Diode 47 an die Basis eines Transistors 48 geführt, welcher in Verbindung mit einem Kondensator 49 und einer Klemmdiode 50 als Ansteuerschaltung eines Impulsgenerators 51, etwa eines monostabilen Multivibrators, fungiert, dessen Timing-Eingang 55 hier z.B. mit einem die Impulsdauer bestimmenden Ladewiderstand 54 und einer Kapazität 56 beschaltet ist.

Der (hier beispielsweise invertierte) Ausgang 53 des Impulsgenerators 51 wirkt hier auf einen Schalttransistor 59. Der Kollektor des Transistors 59 entspricht insoweit dem Ausgang 29 des Impulsgenerators 26 in **Figur 2**. Der Kollektor des Transistors 59 wird über einen Widerstand 60 mit gemäß der Gebersignalamplitude schwimmender "Versorgungsspannung" aus dem Ausgang des Verstärkers 39 gespeist.

Insoweit stellen die Widerstände 40, 44, der Transistor 59 und die Kapazität des Glättungskondensators 46 die Gewichtungsstufe 30 aus **Figur 2** dar. Besagter Glättungskondensator 46 liegt am ersten Eingang eines Komparators 45; diesem wird insoweit die an diesem Kondensator anstehende Bezugsspannung U_{R} zugeführt.

Über einen dritten Entkopplungswiderstand 24A ist das Gebersignal von Klemme 21 über einen Widerstand 43 an den zweiten Eingang des Komparators 45 geführt, hier beispielhaft geschützt durch eine Klemmdiode 41, einen Störschutzkondensator 42 und einen weiteren Vorwiderstand 43. Der Ausgang des Komparators 45 speist die Ausgangsklemme 32.

Die Funktion der schaltungsgemäßen Einrichtung entspricht der i.V. mit Figur 2 vorbeschriebenen, wobei die Gewichtung wie folgt erreicht wird. Mit wachsender Frequenz des an der Klemme 21 anliegenden Gebersignals wird das Tastverhältnis am Kollektor des Transistors 59 kleiner. Dadurch nimmt die aus sich wiederholenden Zeitabschnitten sich durchschnittlich ergebende Zeit, während der der Transistor 59 nichtleitend ist und insoweit den aus dem Ausgang des Verstärkers 39 in Richtung des Kondensators 46 fließenden Strom (wenigstens teilweise) nicht nach Masse ableiten kann, zu. Infolgedessen lädt sich der Glättungskondensator 46 auf ein entsprechend höheres Potential auf, wodurch die Vergleichsspannung U_{S} am zweiten Eingang des Komparators 45 erhöht und als Folge die abfallende Signalflanke am Ausgang des Komparators 45 zeitlich vorverlegt wird.

Andererseits bewirkt eine Erhöhung der Gebersignalspannung eine entsprechend gleichsinnige Erhöhung der für den Transistor 59 und den Kondensator 46 als Quellspannung wirkenden Ausgangsspannung des Verstärkers 39, so daß die Vergleichsspannung des Komparators 45 in entsprechender Weise der Amplitude des Gebersignals nachgeführt wird.

Auf diese Weise gelingt eine Phasenkompensation des periodischen Signals eines induktiven Gebers gegen Frequenz- und Amplitudenänderungen mit sehr hoher Genauigkeit.

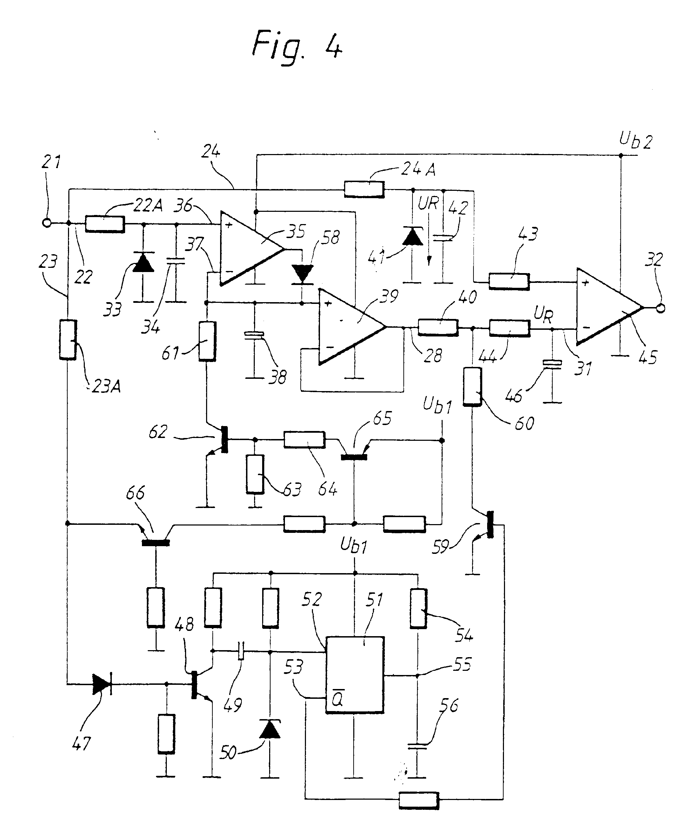

Bei dem Ausführungsbeispiel gemäß **Figur 4** ist die stetige Entladung des Speicherkondensators 38 ersetzt durch eine zeitabschnittsweise und gebersignalsynchrone. Zu diesem Zweck ist die Schaltung gemäß Figur 3 um einen gebersignalgesteuerten Entladekreis 62 bis 66 erweitert.

Der Emittereingang eines in Basisschaltung betriebenen Transistors 66 ist zwischen dem Widerstand 23A und der Diode 47 angeschlossen. Sein kollektorseitiger Arbeitswiderstand wirkt auf die Basis eines komplementären Transistors 65, dessen kollektorseitiger Arbeitswiderstand 64 zusammen mit einem Ableitwiderstand 63 einen Spannungsteiler bildet, an dessen Abgriff die Basis eines Schalttransistors 62 angeschlossen ist. Am Kollektor des Transistors 62 liegt der bereits erwähnte Widerstand 61, während der Emitter des Transistors 62 an Masse liegt.

Die Funktion ist folgende**:**

Der Widerstand 61 ist in Abhängigkeit von der Ansteuerung des Transistors 62 mit Masse verbindbar, d.h. bei zeitabschnittsweiser Ansteuerung entsprechend zeitabschnittsweise. Der Spitzenwert des Gebersignals bleibt so lange im Kondensator 38 gespeichert, bis das Gebersignal ein Grenzpotential von hier beispielsweise ca. - 0.7 V erreicht bzw. unterschreitet. Während aller Zeitabschnitte, in denen das Gebersignal gleich diesem Potential ist oder dieses unterschreitet, wird der Transistor 66 leitend gesteuert. Sein Kollektorstrom bewirkt die Durchsteuerung der Transistoren 65 und 62, so daß die Schaltstrecke des Transistors 62 niederohmig und der Kondensator 38 somit über den Entladewiderstand 61 (und den geringen Sättigungswiderstand der Schaltstrecke des Transistors 62) wenigstens teilweise entladen wird.

Diese Erweiterung bewirkt also, daß der Kondensator 38 definiert entladen bzw. von einem jeweils definierten, entladenen Zustand aus aufgeladen werden kann, wodurch sich eine kürzere Ansprechzeit und ein verbessertes Übergangsverhalten der Einrichtung bei schnellen Änderungen des Gebersignals ergibt.

Der Rahmen der beanspruchten Erfindung wird nicht verlassen, wenn z.B. die Funktion des Impulsgenerators 26 und die der Gewichtungsstufe 30 in einem besonderen Schaltkreis integriert realisiert werden. Ein Beispiel wäre z.B. ein Impulsgenerator, dessen Impulsauslösung vom Gebersignal triggerbar ist und dessen Impulslänge nach Maßgabe durch ein vom Spitzenwertdetektor ausgegebenes Signal steuerbar ist (Impulsweitenmodulation). Der Modulationseingang eines solchen Schaltkreises würde dann sinngemäß vom Widerstand 40 gespeist, während das aus dem Widerstand 44 und dem Glättungskondensator 46 bestehende Tiefpaßglied dann ausschließlich vom Ausgang eines solchen Schaltkreises versorgt würde.

## Patentansprüche

1. Einrichtung zur Auswertung periodischer Signale von induktiven Gebern, welche einen Spitzenwertdetektor (25) umfaßt, der vom Ausgang (21) des induktiven Gebers mit dem Gebersignal beaufschlagbar ist, um in Abhängigkeit von der Gebersignalamplitude den Übergang von einem ersten in einen zweiten logischen Zustand am Ausgang einer nachgeordneten, zwei Eingänge aufweisenden Impulsformerstufe (27) zu beeinflussen, wobei dem ersten Eingang ein veränderbares Bezugssignal (U_{R}) und dem zweitem Eingang das Gebersignal zuführbar ist,
**dadurch gekennzeichnet,**
- daß sie mit dem Gebersignal beaufschlagbare Mittel (26) zur Erzeugung von Impulsen mit einer Wiederholfrequenz umfaßt, welche der Frequenz des Gebersignals entspricht, und
- daß sie des weiteren Gewichtungsmittel (30) umfaßt, welche die Signale vom Ausgang (28) des Spitzenwertdetektors (25) und vom Ausgang (29) der Mittel zur Erzeugung von Impulsen (29) in vorbestimmter Weise zu dem veränderbaren Bezugssignal (U_{R}) verknüpfen.

2. Einrichtung nach Anspruch 1,
**dadurch gekennzeichnet,**
- daß der Impulsformer ein Komparator ist.

3. Einrichtung nach Anspruch 1,
**dadurch gekennzeichnet,**
- daß die Mittel (26) zur Erzeugung von Impulsen mit einer der Frequenz des Gebersignals entsprechenden Wiederholfrequenz wenigstens einen monostabilen Multivibrator umfassen.

4. Einrichtung nach Anspruch 3,
**dadurch gekennzeichnet,**
- daß die Impulse eine konstante Dauer aufweisen.

5. Einrichtung nach Anspruch 1,
**dadurch gekennzeichnet,**
- daß die Gewichtungsmittel (30) wenigstens einen Multiplizierer umfassen.

6. Einrichtung nach Anspruch 1,
**dadurch gekennzeichnet,**
- daß die Gewichtungsmittel (30) wenigstens einen Glättungskondensator (46), einen Ladewiderstand (44) und eine schaltbare Stromquelle (59) umfassen, letztwelche wenigstens einen Teil eines zur Ladung besagten Glättungskondensators (46) bereitgestellten Ladestromes während fester, durch besagte Impulse gebildeter Zeitabschnitte ableitet.

7. Einrichtung nach Anspruch 6,
**dadurch gekennzeichnet,**
- daß der Ladestrom aus einem Verstärkerausgang (39, 28) bereitgestellt wird, dessen Potential nach Maßgabe durch das Ausgangssignal des Spitzenwertdetektors (25; 22A, 33, 34, 35, 38) beeinflußbar ist.

8. Einrichtung nach Anspruch 1,
**dadurch gekennzeichnet,**
- daß die Mittel (26) zur Erzeugung von Impulsen und die Gewichtungsmittel (30) bezüglich ihrer Funktion wenigstens teilweise integriert sind.

9. Einrichtung nach Anspruch 8,
**dadurch gekennzeichnet,**
- daß die funktionsintegrierten Mittel zur Erzeugung von Impulsen (26) und zur Gewichtung (30) einen Impulsgenerator mit vom Gebersignal triggerbarer Impulsauslösung und mit einer nach Maßgabe durch das Ausgangssignal des Spitzenwertdetektors (25) steuerbarer Impulsdauer umfassen.

10. Einrichtung nach Anspruch 9,
**dadurch gekennzeichnet,**
- daß besagte funktionsintegrierte Mittel einen Impulsmodulator umfassen, der auf eine Tiefpaßfunktion (44, 46) wirkt, welcher besagte Impulsformerstufe (27; 45) nachgeschaltet ist.

11. Einrichtung nach Anspruch 1,
**dadurch gekennzeichnet,**
- daß der Spitzenwertdetektor einen Speicherkondensator (38) für den Spitzenwert des Gebersignals umfaßt, und daß Entladungsmittel (61 bis 66) vorhanden sind, welche besagten Speicherkondensator (38) zwecks wenigstens teilweiser Entladung in Abhängigkeit vom Augenblickswert des Gebersignals mit einer definierten Last (61) überbrücken während Zeitphasen, in denen das Gebersignal ein vorgegebenes Grenzpotential unterschreitet.

12. Einrichtung nach Anspruch 11,
**dadurch gekennzeichnet,**
- daß das Grenzpotential bei - 0.7 V liegt.

## Claims

1. Device for evaluating periodic signals from inductive pick-ups, which comprises a peak detector (25) to which the pick-up signal can be applied from the output (21) of the inductive pick-up in order as a function of the pick-up signal amplitude to influence the transition from a first to a second logic state at the output of a downstream pulse former stage (27) having two inputs, it being possible to feed the first input with a variable reference signal (U_{R}) and the second input with the pick-up signal, characterised in that
- it comprises, means (26), to which the pick-up signal can be applied, for generating pulses at a repetition frequency which corresponds to the frequency of the pick-up signal, and
- it comprises, furthermore, weighting means (30) which combine the signals from the output (28) of the peak detector (25) and from the output (26) of the means for generating pulses (29) to form the variable reference signal (U_{R}) in a predetermined fashion.

2. Device according to Claim 1, characterised in that
- the pulse former is a comparator.

3. Device according to Claim 1, characterised in that
- the means (26) for generating pulses at a repetition frequency corresponding to the frequency of the pick-up signal comprise at least one monostable multivibrator.

4. Device according to Claim 3, characterised in that
- the pulses have a constant duration.

5. Device according to Claim 1, characterised in that
- the weighting means (30) comprise at least one multiplier.

6. Device according to Claim 1, characterised in that
- the weighting means (30) comprise at least a smoothing capacitor (46), a charging resistor (44) and a switchable current source (59), of which the latter diverts at least a portion of a charging current provided for charging said smoothing capacitor (46), and does so during fixed time intervals formed by said pulses.

7. Device according to Claim 6, characterised in that
- the charging current is provided from an amplifier output (39, 28) whose potential can be influenced in accordance with the output signal of the peak detector (25; 22A, 33, 34, 35, 38).

8. Device according to Claim 1, characterised in that
- the means (26) for generating pulses and the weighting means (30) are integrated at least partially with respect to their function.

9. Device according to Claim 8, characterised in that
- the functionally integrated means for generating pulses (26) and for weighting (30) comprise a pulse generator, which can be triggered by the pick-up signal and which has a pulse duration that can be controlled as appropriate by the output signal of the peak detector (25).

10. Device according to Claim 9, characterised in that
- the said functionally integrated means comprise a pulse modulator which acts on a low-pass function (44,- 46) which is connected downstream of said pulse former stage (27; 45).

11. Device according to Claim 1, characterised in that
- the peak detector comprises a storage capacitor (38) for the peak value of the pick-up signal, and in that discharging means (61 to 66) are provided which, for the purpose of at least a partial discharge, shunt the said storage capacitor (38) as a function of the instantaneous value of the pick-up signal by means of a defined load (61) during time phases in which the pick-up signal falls below a prescribed limiting potential.

12. Device according to Claim 11, characterised in that
- the limiting potential is - 0.7 V.

## Revendications

1. Dispositif pour évaluer des signaux périodiques de capteurs inductifs, qui comporte un détecteur de valeur maximale (25), qui est chargé par le signal délivré par la sortie (21) du capteur inductif pour influencer, en fonction de l'amplitude du signal du capteur, le passage d'un premier à un second état logique à la sortie d'un étage de mise en forme d'impulsions (27) branché en aval et comportant deux entrées, un signal de référence variable (U_{R}) pouvant être envoyé à la première entrée, tandis que le signal du capteur peut être envoyé à la seconde entrée,
caractérisé par le fait
- qu'il comporte des moyens (26) pouvant être chargés par le signal du capteur pour produire des impulsions ayant une fréquence de récurrence, qui correspond à la fréquence du signal du capteur, et
- qu'il comporte d'autre part des moyens de pondération (30), qui réunissent d'une manière prédéterminée, les signaux de la sortie (28) du détecteur de valeur maximale (25) et de la sortie (29) des moyens de production d'impulsions (29), pour former le signal de référence variable (U_{R}).

2. Dispositif selon la revendication 1,
caractérisé en ce
- que le dispositif de mise en forme d'impulsions est un comparateur.

3. Dispositif selon la revendication 1,
caractérisé en ce
- que les moyens (26) de production d'impulsions présentant une fréquence de récurrence qui correspond à la fréquence du signal du capteur, comprennent au moins un multivibrateur monostable.

4. Dispositif selon la revendication 3,
caractérisé en ce
- que les impulsions possèdent une durée constante.

5. Dispositif selon la revendication 1,
caractérisé en ce
- que les moyens de pondération (30) comprennent au moins un multiplicateur.

6. Dispositif selon la revendication 1,
caractérisé en ce
- que les moyens de pondération (30) comprennent au moins un condensateur de lissage (46), une résistance de charge (44) et une source de courant commutable (59), cette dernière dérivant au moins une partie d'un courant de charge, qui est délivré pour charger ledit condensateur de lissage (46), pendant des intervalles de temps fixes, définis par lesdites impulsions.

7. Dispositif selon la revendication 6,
caractérisé en ce
- que le courant de charge est délivré par une sortie (39, 28) d'un amplificateur, dont le potentiel peut être influencé en fonction du signal de sortie du détecteur de valeur maximale (25;22A,33,34,35,38).

8. Dispositif selon la revendication 1,
caractérisé en ce
- que les moyens (26) de production d'impulsions et les moyens de pondération (30) sont au moins partiellement intégrés, en ce qui concerne leur fonction.

9. Dispositif selon la revendication 8,
caractérisé en ce
- que les moyens (26) de production d'impulsions et les moyens de pondération (30), dont les fonctions sont intégrées, comprennent un générateur d'impulsions, dans lequel la libération des impulsions peut être déclenchée par le signal du capteur et dont la durée des impulsions peut être commandée en fonction du signal de sortie du détecteur de valeur maximale (25).

10. Dispositif selon la revendication 9,
caractérisé en ce
- que lesdits moyens, dont les fonctions sont intégrées, comprennent un modulateur d'impulsions, qui agit sur une unité formant filtre passe-bas (44,46), en aval duquel est branché ledit étage de mise en forme d'impulsions (27;45).

11. Dispositif selon la revendication 1,
caractérisé en ce
- que le détecteur de valeur maximale comporte un condensateur de stockage (38) pour la valeur maximale du signal du capteur et qu'il est prévu des moyens de décharge (61 à 66), ledit condensateur de stockage (38) étant shunté, en vue d'une décharge au moins partielle, en fonction de la valeur instantanée du signal du capteur, par une charge définie (61), pendant des intervalles de temps, pendant lesquels le signal du capteur tombe au-dessous d'un potentiel limite prédéterminé.

12. Dispositif selon la revendication 11,
caractérisé en ce
- que le potentiel limite est égal à -0,7 V.
